(19) Europäisches Patentamt

European Patent Office

Office européen des brevets

(11) **EP 0 813 306 B1**

(12) **EUROPÄISCHE PATENTSCHRIFT**

(45) Veröffentlichungstag und Bekanntmachung des Hinweises auf die Patenterteilung:
**04.10.2001   Patentblatt 2001/40**

(51) Int Cl.⁷: **H03L 1/02**, H03K 17/95

(21) Anmeldenummer: **97810207.7**

(22) Anmeldetag: **09.04.1997**

(54) **Temperaturstabilisierter Oszillator und Verwendung desselben in einem Näherungsschalter**

Temperature stabilised oscillator and proximity switch using the same

Oscillateur stabilisé en température et commutateur de proximité en faisant usage

(84) Benannte Vertragsstaaten:
**AT BE DE FR GB IT NL SE**

(30) Priorität: **13.06.1996   CH 148296**

(43) Veröffentlichungstag der Anmeldung:
**17.12.1997   Patentblatt 1997/51**

(73) Patentinhaber: **Optosys SA**
**1752 Villars-sur-Glâne (CH)**

(72) Erfinder: **Heimlicher, Peter**
**1700 Fribourg (CH)**

(74) Vertreter:
**AMMANN PATENTANWAELTE AG BERN**
**Schwarztorstrasse 31**
**3001 Bern (CH)**

(56) Entgegenhaltungen:
**EP-A- 0 070 796**

• **PATENT ABSTRACTS OF JAPAN vol. 017, no. 378 (E-1398), 15.Juli 1993 & JP 05 063559 A (SHARP CORP), 12.März 1993,**

## Beschreibung

Die Erfindung betrifft einen temperaturstabilisierten Oszillator gemäss dem Oberbegriff des Patentanspruchs 1. Weiterhin betrifft die Erfindung die Verwendung eines solchen Oszillators in einem Näherungsschalter.

Oszillatoren, welche einen LC-Schwingkreis aufweisen, werden z.B. in induktiven Näherungsschaltern verwendet, wobei die Annäherung einer sogenannten Normmessplatte das Verhalten der durch den Oszillator erzeugten Schwingung beeinflusst. Dabei verändert sich beispielsweise die Amplitude des Ausgangssignals des Oszillators oder der Einsatzpunkt der Schwingung, wodurch ein Schwellenwertdetektor gesteuert wird, der ein nutzbares Ausgangssignal des Näherungsschalters liefert.

Der Hauptnachteil handelsüblicher induktiver Näherungsschalter besteht in ihrem relativ kleinen Schaltabstand. Einer Erhöhung dieses Schaltabstandes steht die Temperaturabhängigkeit der verwendeten Oszillator-Schwingkreiskombination entgegen, die bei erhöhtem Schaltabstand zu einem normalerweise nicht akzeptablen Temperaturkoeffizienten desselben fuhrt.

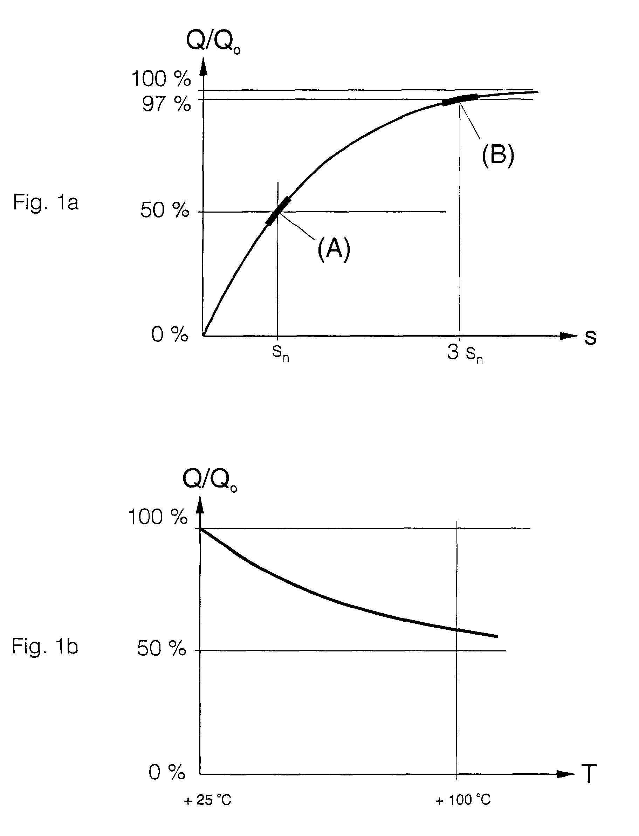

Figur 1a zeigt das Verhalten der relativen Schwingkreisgüte $Q/Q_0$ in Funktion der Distanz S (Schaltabstand) der Normmessplatte eines induktiven Naherungsschalters. Mit zunehmendem Schaltabstand sinkt die durch die Normmessplatte bewirkte, nutzbare Änderung $(Q_0-Q)$ der Schwingkreisgüte Q relativ zur ungedämpften Schwingkreisgüte $Q_0$ rasch auf einen sehr kleinen Wert. Ist der normale Arbeitsbereich so gewählt, dass für einen gegebenen Schaltabstand die relative Schwingkreisgüte 50% betragt (Arbeitspunkt A), so zeigt die Kurve von Figur 1a, dass sich der Einfluss der Normmessplatte auf die relative Schwingkreisgüte für einen dreimal so grossen Schaltabstand auf ca. 3% reduziert (Arbeitspunkt B).

Der Einfluss der Umgebungstemperatur T auf die relative Schwingkreisgute ist in Figur 1b wiedergegeben, welche zeigt, dass das Verhältnis $Q/Q_0$ mit steigender Temperatur abnimmt. Ein Vergleich mit Figur 1a lasst erkennen, dass bei grosseren Schaltabstanden der Temperatureinfluss auf $Q/Q_0$ rasch grosser wird als die durch die Normmessplatte bewirkte Änderung. Dieser Temperatureinfluss wird zum weitaus grössten Teil durch die Temperaturabhangigkeit des Widerstandes der Schwingkreisspule verursacht.

Es ist aus der DE-A-1 589 826 eine Spulenanordnung mit kleiner Temperaturabhängigkeit der Güte bekannt. Die Temperaturkompensation der Güte der Spule wird erzielt, indem diese Spule als Primärwicklung eines Transformators geschaltet ist, dessen Sekundärkreis kurzgeschlossen ist. Der spezifische Widerstand des Leitmaterials der Sekundärwicklung hat eine Temperaturabhangigkeit gleichen Vorzeichens wie der spezifische Widerstand des Leitermaterials der Primärwicklung. Der Kopplungsfaktor sowie das Verhältnis des ohmschen Wicklungswiderstandes zum induktiven Widerstand dieser Wicklung werden so gewählt, dass die Güte, die an den Anschlüssen der Primärwicklung auftritt, eine geringere Temperaturabhängigkeit hat, als die Güte der Primärwicklung allein. Jedoch braucht diese Güte-Kompensation eine zweite, kurzgeschlossene Wicklung, die als Sekundärwicklung eines Transformators geschaltet ist, und die Kompensation, welche nicht vollständig ist, wird durch eine relativ grosse Verminderung des Gütefaktors erkauft.

Die EP-A-0 070 796 beschreibt ein Verfahren, bei dem die Temperaturabhängigkeit des Widerstandes der Schwingkreisspule dazu benutzt wird, das durch eben diesen Einfluss schlechte Temperaturverhalten der Schwingamplitude des durch einen Generator angeregten Schwingkreises zu kompensieren. Dabei wird eine zum Widerstand der Schwingkreisspule proportionale Spannung an den Schwingkreis angelegt. Der Generator erzeugt einen konstanten Wechselstrom der gleichen Frequenz wie die des Schwingkreises durch den Widerstand der Schwingkreisspule. Dieses Verfahren ermöglicht die grössten zur Zeit realisierbaren Schaltabstände.

Dieses bekannte Verfahren benötigt eine bifilare Spule zur Erzielung der gewünschten Kompensation des Temperatureinflusses. Diese Art von Spule hat unter anderem den Nachteil, dass ein bzw. zwei zusätzliche Drähte anzuschliessen sind. Dadurch entstehen zusätzliche Kosten in der Fertigung sowohl der Spule selbst wie auch bei deren Verbindung mit der elektronischen Schaltung. Zudem ist die automatische Fertigung sowohl der Spule wie auch deren Anschluss sehr schwierig.

Es ist ferner aus der Publikation "Patent Abstracts of Japan Vol. 017, No. 378 (E-1398), 15. Juli 1993 & JP 05 063559 A (SHARP CORP), 12. März 1993, eine Oszillatorschaltung bekannt, welcher einen Schwingkreis mit einer Spule, die einen Kupferwiderstand hat, und eine als virtueller negativer Widerstand geschaltete Verstärkerschaltung enthält, wobei die Oszillatorschaltung so eingerichtet ist, dass zwischen beiden Enden der Schwingkreisspule eine Spannung auftritt, welche eine Gleichstromkomponente und eine Komponente der Resonanzfrequenz hat. Zur Kompensation des Einflusses der Umgebungstemperatur auf die relative Schwingkreisgüte enthält diese bekannte Oszillatorschaltung eine Rückkopplung der Spulenspannung via eine Verstärkerschaltung (D), wobei die Grösse der Verstärkung dieser Verstärkungsschaltung (D) durch eine zusätzliche Schaltung (E) eingestellt wird, die eine negative Temperaturkennlinie hat, und wobei eine Änderung des Temperaturkoeffizients der Schaltung (E) durch eine Änderung einer Schaltungskonstante erzielt wird.

Der Erfindung liegt die Aufgabe zugrunde, einen gattungsgemässen Oszillator zu schaffen, welcher ohne die oben genannten Nachteile eine wirksame Kompensation der Auswirkungen der Temperaturabhängigkeit des Widerstandes der Schwingkreisspule auf das Schwingverhalten des Schwingkreises gewährleistet, wodurch die einfache und kostengünstige Herstellung induktiver Näherungsschalter mit grossen Schaltabständen möglich wird.

Erfindungsgemäss wird dies durch die Merkmale des kennzeichnenden Teils des Patentanspruchs 1 erreicht. Durch die Ermittlung des Signals, welches ein Mass ist für den Widerstand der Schwingkreisspule, mittels der Stromquelle und die Steuerung des negativen Widerstandes mit Hilfe dieses Signals umgekehrt proportional zum Widerstand der Schwingkreisspule ist die Schwingbedingung des Schwingkreises unabhängig vom Widerstand der Schwingkreisspule und somit im wesentlichen temperaturunabhängig geworden. Dies ergibt eine Stabilisierung des Temperaturverhaltens des Einsatzpunktes der Schwingung des Schwingkreises, was einen stabilen Oszillator und somit einen einfachen Näherungsschalter mit einem grossen Schaltabstand ermöglicht, der in einem breiten Temperaturbereich zuverlässig funktioniert.

Weitere vorteilhafte Ausführungsformen gehen aus den Unteransprüchen hervor.

Nachfolgend werden einige beispielsweise Ausführungsformen der Erfindung an Hand der Zeichnung näher erläutert. Es zeigen:

Fig. 1a     das Verhalten der relativen Schwingkreisgüte eines induktiven Näherungsschalters in Funktion des Schaltabstandes,

Fig. 1b     das Verhalten der relativen Schwingkreisgüte eines induktiven Näherungsschalters in Funktion der Temperatur,

Fig. 2     das Schaltbild eines Oszillators mit einem parallel zu einem virtuellen negativen Widerstand geschalteten LC-Schwingkreis,

Fig. 3     das Schaltbild eines Oszillators gemäss einer ersten Ausführungsform der Erfindung, und

Fig. 4     das Schaltbild eines Oszillators gemäss einer weiteren Ausführungsform der Erfindung.

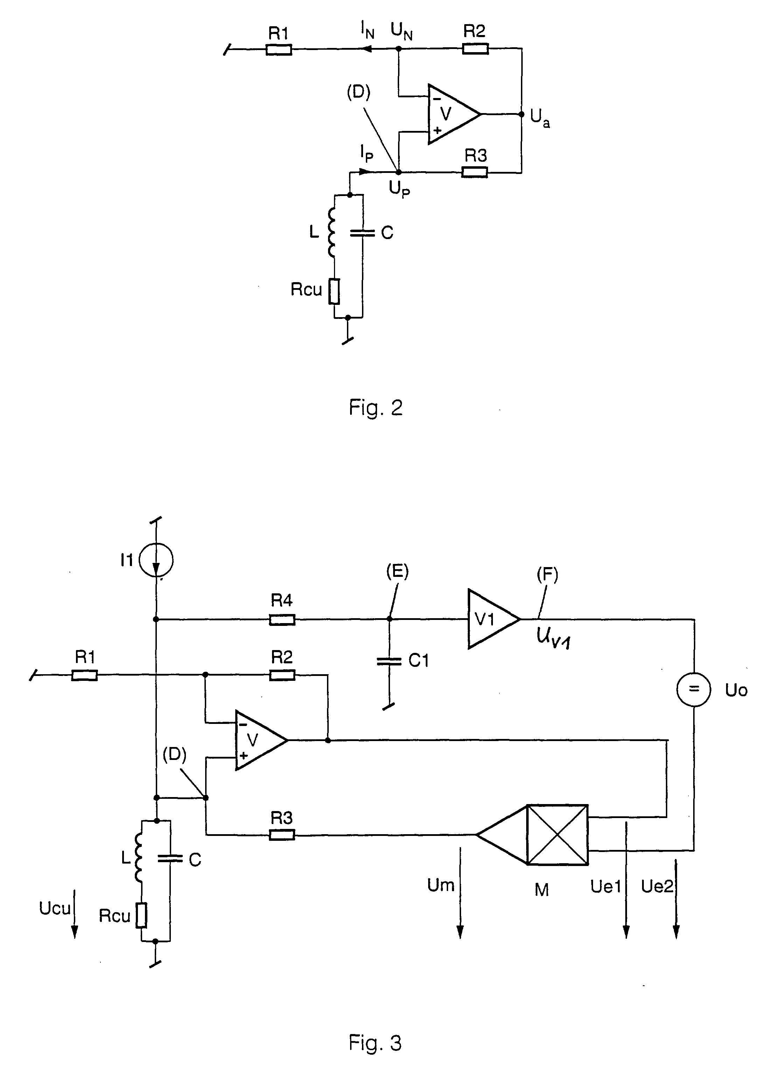

In Figur 2 ist das Schaltbild eines Oszillators mit einem parallel zu einem virtuellen negativen Widerstand geschalteten LC-Schwingkreis wiedergegeben. Der Oszillator gemass Figur 2 ist in bekannter Art aufgebaut und besteht aus dem durch die Spule L (mit Induktivität L) und den Kondensator C (mit Kapazität C) gebildeten Schwingkreis, dem Kupferwiderstand $R_{CU}$ der Schwingkreisspule L und dem als negativer Widerstand geschalteten Verstärker V mit den drei den virtuellen negativen Widerstand $R_n$ am Punkt (D) bestimmenden Widerständen $R_1$, $R_2$ und $R_3$. Der ohmsche Widerstand der jeweiligen Widerstande $R_1$ wird der Einfachheit halber auch mit $R_1$ bezeichnet.

Der Widerstand $R_1$ ist zwischen Masse und den invertierenden (oder N-)Eingang des Verstärkers V geschaltet. Der Widerstand $R_2$ ist zwischen den invertierenden Eingang des Verstärkers V und den Ausgang desselben geschaltet. Der Widerstand $R_3$ ist zwischen den nichtinvertierenden (oder P-)Eingang des Verstärkers V und den Ausgang desselben geschaltet. Der Schwingkreis L, C, $R_{CU}$ ist zwischen den nichtinvertierenden Eingang des Verstärkers V und Masse geschaltet.

Die Anwendung der Knotenregel auf den N- und P-Eingang des Verstärkers V ergibt in an sich bekannter Weise für die in Figur 2 dargestellten Ströme $I_N$, $I_P$ und Spannungen $U_N$, $U_P$ und $U_a$ (Ausgangsspannung des Verstärkers V) :

$$-I_N + (U_a - U_N)/R_2 = 0$$

$$I_p + (U_a - U_P)/R_3 = 0$$

Zusatzlich gilt:

$$U_N = U_P$$

$$U_N - I_N * R_1 = 0$$

Daraus folgt:

$$I_N = (-R_3/R_2) * I_P$$

$$U_P + (R_1 - R_3/R_2) * I_P = 0$$

und damit:

$$R_n = - R_1 * R_3 / R_2 \qquad (1)$$

Der aus L, C und $R_{CU}$ bestehende Schwingkreis hat bei Resonanz den (nicht gezeigten) äquivalenten Resonanzwiderstand $R_p$. Es gilt:

$$R_p = L / (C * R_{CU}) \qquad (2)$$

Die Schwingbedingung für den Oszillator gemass Figur 2 ist:

$$|R_p| \geq |R_n| \qquad (3)$$

Er schwingt mit der Frequenz $F_{osc}$ (z. B. in der Grössenordnung von einigen hundert kHz).

Der Widerstand $R_{CU}$ des Leitermaterials der Spule L besitzt einen relativ hohen, positiven Temperaturkoeffizienten, der gemäss den Gleichungen (2) und (3) das Ein- bzw. Aussetzen der Schwingung des Schwingkreises beeinflusst. Der Einsatz-bzw. Abreisspunkt der Schwingung wird jedoch bei Näherungsschalter-Oszillatoren in an sich bekannter Weise als Folge der Annäherung einer Normmessplatte von einer Auswerteschaltung festgestellt und als Schaltpunkt für den Näherungsschalter benutzt. Jeglicher Einfluss der Temperatur auf diesen Schaltpunkt ist also unerwünscht. Der weitaus grösste Temperatureinfluss stammt bei bekannten Oszillatoren vom Widerstand $R_{CU}$ der Schwingkreisspule L.

Figur 3 zeigt das Schaltbild eines Oszillators gemäss einer ersten Ausführungsform der Erfindung. Zur Ermittlung des temperaturabhängigen Kupferwiderstandes $R_{CU}$ der Schwingkreisspule L dient die Konstantstromquelle $I_1$, die zwischen Masse und den nichtinvertierenden Eingang des Verstärkers V in Serie zum Schwingkreis L, C, $R_{CU}$ geschaltet ist. Die Stromquelle $I_1$ kann auch eine pulsierende Gleichstromquelle oder eine niederfrequente Wechselstromquelle (mit einer Frequenz, welche viel niedriger ist als $F_{osc}$) sein. Sie liefert einen Messstrom $I_1$, welcher am Widerstand $R_{CU}$ der Schwingkreisspule L einen Spannungsabfall $U_{CU}$ hervorruft:

$$U_{CU} = R_{CU} * I_1 \qquad (4)$$

Ihre Impedanz wird so hoch gewählt, dass der Schwingkreis L, C, $R_{CU}$ nicht nennenswert gedämpft wird. Aus dem Spannungsabfall $U_{CU}$ wird zuerst mit Hilfe des durch den Kondensator $C_1$ und den Widerstand $R_4$ gebildeten Tiefpasses der Wechselspannungsanteil weggefiltert. Der Gleichspannungsanteil am Punkt (E) wird in einem nichtinvertierenden Gleichspannungsverstärker $V_1$ um den Faktor G verstärkt. Am Ausgang (F) des Verstärkers $V_1$ steht die zum Kupferwiderstand $R_{CU}$ proportionale Gleichspannung $U_{V1}$ zur Verfügung:

$$U_{V1} = R_{cu} * I_1 * G \qquad (5)$$

Gemäss Figur 3 ist zwischen den Ausgang (F) des Verstärkers $V_1$ und den einen Eingang eines Multiplizierers M eine Konstantspannungsquelle $U_0$ geschaltet. Zur Vereinfachung der Formel wird die Konstante k wie folgt definiert:

$$k = R_1/(R_1+R_2) \qquad (6)$$

Die Spannungsquelle $U_0$ dient dazu, zur Spannung $U_{V1}$ an (F) eine konstante Spannung der Grösse $k*U_0$ zu addieren. Die Summe dieser Spannungen wird mit $U_{e2}$ bezeichnet. Statt der in Serie geschalteten Spannungsquelle $U_0$ kann die gewünschte Spannung natürlich auch mit einem Addierer eingebracht werden.

Im weiteren ist zwischen den Ausgang des Verstärkers V und den Widerstand $R_3$ (dieser Strompfad bestimmt gemäss Gleichung (1) den virtuellen negativen Widerstand $R_n$ an (D) mit) der schon erwähnte Multiplizierer M geschaltet. Er berechnet ($U_{e1}$ ist die Ausgangsspannung des Verstärkers V):

$$U_m = U_{e1} * U_{e2} / U_0 \qquad (7)$$

Die Spannung $U_0$ ist die Referenzspannung des Multiplizierers M.

Der virtuelle negative Widerstand $R_n$ an (D) kann wiederum durch Anwendung der Knotenregel auf den N- und P-Eingang des Verstärkers V berechnet werden (die Ströme $I_N$, $I_P$ und Spannungen $U_N$, $U_P$ entsprechen den in Figur 2 dargestellten Strömen und Spannungen, sind jedoch der Einfachheit halber in Figur 3 nicht wiedergegeben):

$$-I_N + (U_{e1} - U_N)/R_2 = 0$$

$$I_P + (U_m - U_P)/R_3 = 0$$

Zusätzlich gilt:

$$U_N = U_P$$

$$U_N - I_N*R_1 = 0$$

Daraus folgt:

$$U_{e1} = I_N*(R_1+R_2) = U_P/k$$

$$I_P = (U_P - U_{e1}*U_{e2}/U_0) / R_3$$

$$= [U_P - (U_P/k)*(U_{V1}+k*U_0) /U_0] / R_3$$

$$= -(U_P*U_{V1})/(k*U_0*R_3)$$

$$U_P = [-(k*U_0*R_3)/U_{V1}]*I_P$$

und damit:

$$R_n = - k * R_3 * U_0 / U_{V1} \qquad (8)$$

und mit (5) in (8) eingesetzt:

$$R_n = -(k * R_3 * U_0) / (R_{CU} * I_1 * G) \qquad (9)$$

Der virtuelle negative Widerstand $R_n$ ist somit umgekehrt proportional zum Kupferwiderstand $R_{CU}$ der Schwingkreisspule L gesteuert, wodurch die durch $R_{CU}$ bedingte Temperaturabhängigkeit des Schwingverhaltens des Oszillators gemäss Figur 2 ideal kompensiert wird. Mit Hilfe der Auswertung des Kupferwiderstandes $R_{CU}$ der Schwingkreisspule L sowie der Rückkopplung des Signals $U_{CU}$ bzw. $U_{V1}$ wird die Schwingbedingung für den Oszillator (siehe Gleichung (3)) nämlich unabhängig von $R_{CU}$ und daher im wesentlichen temperaturunabhängig. Somit ist eine Kompensation des Einflusses des Temperaturkoeffizienten des Widerstandes $R_{CU}$ der Schwingkreisspule L auf den Einsatzpunkt der Schwingung des Schwingkreises C, L, $R_{CU}$ realisiert, ohne dass die Verwendung einer bifilaren Spule nötig wäre. Die verwendete Schwingkreisspule L ist eine einfache Spule mit einer Wicklung und zwei Anschlüssen, ohne irgendwelche speziellen Anforderungen an die Spule.

Die Steuerung des virtuellen negativen Widerstandes $R_n$ umgekehrt proportional zum Kupferwiderstand $R_{CU}$ der Schwingkreisspule L, und somit die Temperaturkompensation des Oszillators, ist dadurch erreicht, dass die Ausgangsspannung $U_{e1}$ des Verstarkers V mit einem Faktor multipliziert wird, der eine lineare Funktion des Widerstandes $R_{CU}$ der Spule L ist.

Diese Multiplikation und die Erzeugung des geeigneten Faktors können vorteilhaft mit der kostengünstigen Steuerschaltung gemass Figur 3 vorgenommen werden. Andere Ausführungsformen der Steuerschaltung sind jedoch ohne weiteres möglich. So kann statt des gezeigten Multiplizierers M auch eine Ausführung nach dem Time-Division-Verfahren eingesetzt werden, oder das Signal kann zuerst digitalisiert und die Multiplikation mit einem multiplizierenden Digital/Analog-Wandler vorgenommen werden. Die gesamte Steuerung kann auch rein digital, zum Beispiel mit einem Digital Signal Processor, realisiert werden.

Die Stromquelle $I_1$ ist vorzugsweise von der Spannungsquelle $U_0$ abgeleitet, oder umgekehrt. Dadurch wird erreicht, dass (gemäss Gleichung (9): $U_0$ im Zähler, $I_1$ im Nenner) der negative Widerstand $R_n$ von einer eventuellen Unstabilität der Spannungsquelle $U_0$ oder der Stromquelle $I_1$ nicht beeinträchtigt wird. Somit entfällt die Notwendigkeit einer Stabilisierung der Spannungsquelle $U_0$ und der Stromquelle $I_1$.

Die Spannungsquelle $U_0$ kann eventuell weggelassen werden, was zur Folge hat, dass der virtuelle negative Widerstand $R_n$ nicht genau umgekehrt proportional zum Kupferwiderstand $R_{CU}$ der Schwingkreisspule L wird. Die Temperaturkompensation ist dann etwas weniger gut.

Bei der Verwendung eines erfindungsgemässen Oszillators in einem Näherungsschalter wird der temperaturkompensierte Einsatz- bzw. Abreisspunkt der Schwingung bei Annäherung einer Normmessplatte in an sich bekannter Weise von einer (nicht gezeigten) Auswerteschaltung, beispielsweise mit Hilfe eines Schwellenwertdetektors, festgestellt und als Schaltpunkt für den Naherungsschalter verwendet.

Der Kupferwiderstand $R_{CU}$ der Schwingkreisspule L betragt in der Regel nur einige Ohm, und der in der Praxis für $I_1$ zur Verfügung stehende Strom liegt in der Grössenordnung von 1 mA. Die nutzbare Spannung $U_{CU}$ beträgt deshalb nur einige mV. Es ist schwierig, diese kleine Spannung mit der erforderlichen Genauigkeit zu verstärken. Vor allem die Offsetspannung des Verstärkers $V_1$ macht sich störend bemerkbar. Zur Vermeidung dieses Problems kann der Verstärker $V_1$ nach dem bekannten Prinzip des Chopper-Verstärkers ausgeführt werden.

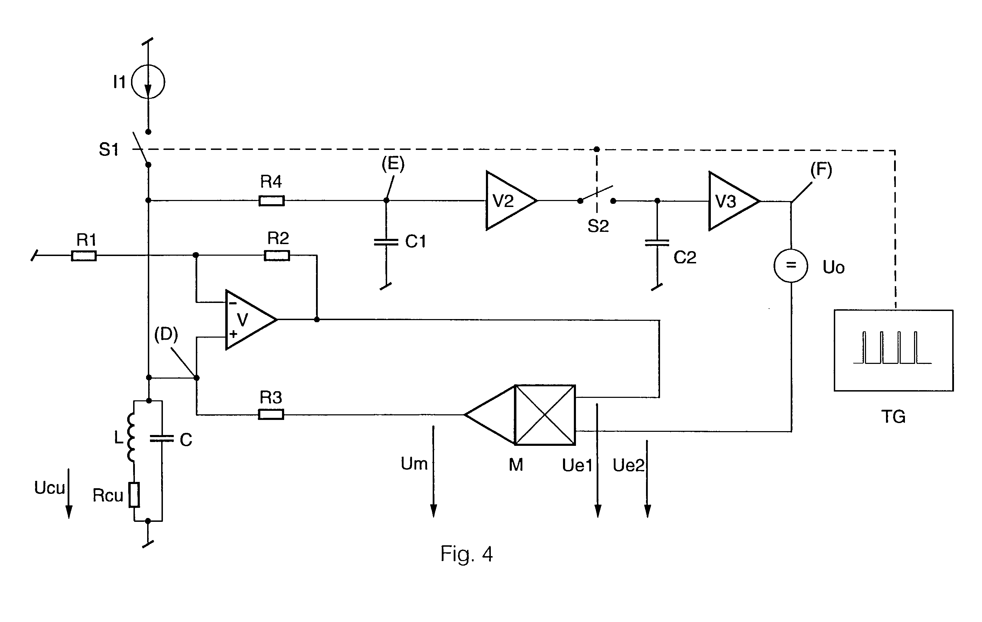

In Figur 4 ist das Schaltbild eines Oszillators gemäss einer weiteren Ausführungsform der Erfindung wiedergegeben. Statt den Verstarker $V_1$ als Chopperverstarker auszuführen, wird zur Verstärkung des Spannungsabfalles $U_{CU}$ eine Sample-Hold-Schaltung verwendet. Die Stromquelle $I_1$ wird mittels des Taktgenerators TG und des Schalters $S_1$ mit der Frequenz $F_{tg}$, die wesentlich kleiner (in der Grössenordnung von einigen Hz) als $F_{osc}$ ist, getaktet. Das Taktverhältnis des Taktgenerators TG kann zur Reduktion des von der Stromquelle $I_1$ verbrauchten Stromes klein gewählt werden.

Der Wechselspannungsanteil der Spannung am Punkt (E) wird im nichtinvertierenden Wechselspannungsverstärker $V_2$ verstärkt. Anschliessend wird mit der aus dem Schalter $S_2$, dem Haltekondensator $C_2$ und dem Spannungsfolger $V_3$ bestehenden Sample-Hold-Schaltung der Gleichspannungsanteil wieder hergestellt. Die Offsetspannung des Verstärkers $V_3$ fällt gegenüber der bereits im Verstärker $V_2$ verstärkten Nutzspannung $U_{CU}$ nicht mehr ins Gewicht.

**Patentansprüche**

1. Temperaturstabilisierter Oszillator mit einem Schwingkreis (L, C, $R_{CU}$), welcher eine Spule enthält, die einen Kupferwiderstand ($R_{CU}$) hat, und einer als virtueller negativer Widerstand ($R_n$) geschalteten Verstärkerschaltung (V, $R_1$, $R_2$, $R_3$),

   wobei der Oszillator so eingerichtet ist, dass zwischen beiden Enden der Schwingkreisspule (L) eine Spannung ($U_{CU}$) auftritt, welche eine Komponente ausserhalb der Resonanzfrequenz hat,

   welcher Oszillator **dadurch gekennzeichnet ist, dass** er Mittel enthält, mit denen aus der Spannung ($U_{CU}$), welcher zwischen beiden Enden der Schwingkreisspule (L) auftritt, eine erste Spannung ($U_{V1}$) ableitbar ist, welche im wesentlichen dem Kupferwiderstand ($R_{CU}$) der Schwingkreisspule (L) proportional ist und keine Komponente mit der Frequenz der Resonanzfrequenz des Schwingkreises enthält, und

eine Steuerschaltung ($V_1$, M; $V_2$, $V_3$, M) enthält, welche mittels der ersten Spannung ($U_{V1}$) den virtuellen negativen Widerstand ($R_n$) im wesentlichen umgekehrt proportional zum Kupferwiderstand ($R_{CU}$) der Schwingkreisspule (L) macht.

2. Oszillator nach Anspruch 1, **dadurch gekennzeichnet, dass** die Steuerschaltung ($V_1$, M; $V_2$, $V_3$, M) eine Ausgangsspannung ($U_{e1}$) der Verstärkerschaltung (V, $R_1$, $R_2$, $R_3$) aufgrund einer zweiten Spannung ($U_{e2}$) einstellt, die eine lineare Funktion der vorgenannten ersten Spannung ($U_{CU}$) ist.

3. Oszillator nach Anspruch 1, **dadurch gekennzeichnet, dass** die Stromquelle ($I_1$) eine Gleichstromquelle, eine pulsierende Gleichstromquelle oder eine niederfrequente Wechselstromquelle ist.

4. Oszillator nach einem der Ansprüche 1-3, **dadurch gekennzeichnet, dass** die Steuerschaltung ($V_1$, M; $V_2$, $V_3$, M) die Ausgangsspannung ($U_{e1}$) der Verstärkerschaltung (V, $R_1$, $R_2$, $R_3$) mit einer Spannung multipliziert, die eine lineare Funktion des Signales ($U_{CU}$) ist.

5. Oszillator nach einem der Ansprüche 1 bis 4, **dadurch gekennzeichnet, dass** der Schwingkreis (L, C, $R_{CU}$) mit dem nichtinvertierenden Eingang eines Verstärkers (V) und ein erster Widerstand ($R_1$) mit dem invertierenden Eingang des Verstärkers (V) verbunden ist, ein zweiter Widerstand ($R_2$) zwischen den invertierenden Eingang des Verstärkers (V) und den Ausgang desselben, ein dritter Widerstand ($R_3$) zwischen den nichtinvertierenden Eingang des Verstärkers (V) und die Steuerschaltung ($V_1$, M; $V_2$, $V_3$, M) geschaltet ist, und der Ausgang des Verstärkers ($V_1$) mit der Steuerschaltung ($V_1$, M; $V_2$, $V_3$, M) verbunden ist.

6. Oszillator nach Anspruch 5, **dadurch gekennzeichnet, dass** der nichtinvertierende Eingang des Verstärkers (V) über einen weiteren Verstärker ($V_1$; $V_2$, $V_3$) mit einem Eingang eines Multiplizierers (M) verbunden ist, dessen weiterer Eingang mit dem Ausgang des Verstärkers (V) verbunden ist, und dessen Ausgang über den dritten Widerstand ($R_3$) wiederum mit dem nichtinvertierenden Eingang des Verstärkers (V) verbunden ist.

7. Oszillator nach Anspruch 6, **dadurch gekennzeichnet, dass** zwischen den einen Eingang des Verstärkers (V) und den Eingang des weiteren Verstärkers ($V_1$; $V_2$, $V_3$) ein Tiefpass ($R_4$, $C_1$) geschaltet ist.

8. Oszillator nach einem der Ansprüche 6 oder 7, **dadurch gekennzeichnet, dass** zwischen den Ausgang des weiteren Verstärkers ($V_1$; $V_2$) und den Eingang des Multiplizierers (M) eine Spannungsquelle ($U_0$) zum Addieren einer Spannung geschaltet ist.

9. Oszillator nach Anspruch 8, **dadurch gekennzeichnet, dass** die Spannungsquelle ($U_0$) zur Ausgangsspannung ($U_{V1}$) des weiteren Verstärkers ($V_1$; $V_2$, $V_3$) *eine konstante Spannung von der Grösse $k*U_0$ addiert,* wobei k = $R_1/(R_1+R_2)$ und die Spannung $U_0$ die Referenzspannung des Multiplizierers (M) ist.

10. Oszillator nach einem der Ansprüche 8 oder 9, **dadurch gekennzeichnet, dass** die Stromquelle ($I_1$) von der Spannungsquelle ($U_0$) abgeleitet ist, oder umgekehrt.

11. Oszillator nach einem der Ansprüche 6 bis 10, **dadurch gekennzeichnet, dass** der weitere Verstärker als nichtinvertierender Gleichspannungsverstärker ($V_1$) ausgeführt ist.

12. Oszillator nach einem der Ansprüche 6 bis 10, **dadurch gekennzeichnet, dass** der weitere Verstärker als Chopper-Verstärker ($V_1$) ausgeführt ist.

13. Oszillator nach einem der Ansprüche 6 bis 10, **dadurch gekennzeichnet, dass** der weitere Verstärker als nichtinvertierender Wechselspannungsverstärker ($V_2$) ausgeführt ist, wobei ein Taktgenerator (TG) und ein Schalter ($S_1$) zum Takten der Stromquelle ($I_1$) sowie eine Sample-Hold-Schaltung ($S_2$, $C_2$, $V_3$) zum Wiederherstellen der Gleichspannungskomponente des vom Wechselspannungsverstärker ($V_2$) verstärkten Signals vorgesehen sind.

14. Verwendung eines Oszillator nach einem der Ansprüche 1 bis 13 in einem Näherungsschalter.

15. Verwendung eines Oszillator nach einem der Ansprüche 1 bis 13 in einem Näherungsschalter, welcher eine Auswerteschaltung zum Feststellen des Einsatz- bzw. Abreisspunktes der durch den Oszillator erzeugten Schwingung als Folge der Annäherung einer Normmessplatte aufweist.

## Claims

1. Temperature-stabilized oscillator, comprising a resonant circuit (L, C, $R_{CU}$) containing a coil which has a copper resistance ($R_{CU}$), and comprising an amplifier circuit (V, $R_1$, $R_2$, $R_3$) connected as a virtual negative resistance ($R_n$),

   the oscillator being so arranged that a voltage ($U_{CU}$) having a component outside the resonant frequency occurs across the two ends of the resonant circuit coil (L), which oscillator is **characterized in that**

it contains means with which a first voltage ($U_{V1}$), which is substantially proportional to the copper resistance ($R_{CU}$) of the resonant circuit coil (L) and does not contain any component having the frequency of the resonant frequency of the resonant circuit, can be derived from the voltage ($U_{CU}$) that occurs across the two ends of the resonant circuit coil (L), and

it contains a control circuit ($V_1$, M; $V_2$, $V_3$, M) which, by means of the first voltage ($U_{V1}$), makes the virtual negative resistance ($R_n$) substantially inversely proportional to the copper resistance ($R_{CU}$) of the resonant circuit coil (L).

2. Oscillator according to claim 1, **characterized in that** the control circuit ($V_1$, M; $V_2$, $V_3$, M) adjusts an output voltage ($U_{e1}$) of the amplifier circuit (V, $R_1$, $R_2$, $R_3$) on the basis of a second voltage ($U_{e2}$) which is a linear function of the above-mentioned first voltage ($U_{CU}$).

3. Oscillator according to claim 1, **characterized in that** the current source ($I_1$) is a direct current source, a pulsating direct current source or a low-frequency alternating current source.

4. Oscillator according to any one of claims 1 to 3, **characterized in that** the control circuit ($V_1$, M; $V_2$, $V_3$, M) multiplies the output voltage ($U_{e1}$) of the amplifier circuit (V, $R_1$, $R_2$, $R_3$) by a voltage which is a linear function of the signal ($U_{CU}$).

5. Oscillator according to any one of claims 1 to 4, **characterized in that** the resonant circuit (L, C, $R_{CU}$) is connected to the non-inverting input of an amplifier (V), and a first resistance ($R_1$) is connected to the inverting input of the amplifier (V), a second resistance ($R_2$) is connected between the inverting input of the amplifier (V) and its output, a third resistance ($R_3$) is connected between the non-inverting input of the amplifier (V) and the control circuit ($V_1$, M; $V_2$, $V_3$, M) , and the output of the amplifier (V) are connected to the control circuit ($V_1$, M; $V_2$, $V_3$, M).

6. Oscillator according to claim 5, **characterized in that** the non-inverting input of the amplifier (V) is connected through a further amplifier ($V_1$; $V_2$, $V_3$) to one input of a multiplier (M) whose other input is connected to the output of the amplifier (V) and whose output is in turn connected through the third resistance ($R_3$) to the non-inverting input of the amplifier (V).

7. Oscillator according to claim 6, **characterized in**

**that** a low pass filter ($R_4$, $C_1$) is connected between the one input of the amplifier (V) and the input of the further amplifier ($V_1$; $V_2$, $V_3$).

8. Oscillator according to either claim 6 or claim 7, **characterized in that** a voltage source ($U_o$) is connected between the output of the further amplifier ($V_1$; $V_2$) and the input of the multiplier (M) for adding a voltage.

9. Oscillator according to claim 8, **characterized in that** the voltage source ($U_o$) adds a constant voltage of size $k*U_o$ to the output voltage ($U_{v1}$) of the further amplifier ($V_1$; $V_2$, $V_3$), k being equal to $R_1/(R_1+R_2)$ and the voltage $U_o$ being the reference voltage of the multiplier (M).

10. Oscillator according to either claim 8 or claim 9, **characterized in that** the current source ($I_1$) is derived from the voltage source ($U_o$) or vice versa.

11. Oscillator according to any one of claims 6 to 10, **characterized in that** the further amplifier is in the form of a non-inverting direct voltage amplifier ($V_1$).

12. Oscillator according to any one of claims 6 to 10, **characterized in that** the further amplifier is in the form of a chopper amplifier ($V_1$).

13. Oscillator according to any one of claims 6 to 10, **characterized in that** the further amplifier is in the form of a non-inverting alternating voltage amplifier ($V_2$), a clock generator (TG) and a switch ($S_1$) for clocking the current source ($I_1$) being provided as well as a sample-and-hold circuit ($S_2$, $C_2$, $V_3$) for restoring the direct voltage component of the signal amplified by the alternating voltage amplifier ($V_2$).

14. Use of an oscillator according to any one of claims 1 to 13 in a proximity switch.

15. Use of an oscillator according to any one of claims 1 to 13 in a proximity switch which has an evaluating circuit for determining the start and break point of the oscillation generated by the oscillator as a result of the approach of a standard measuring plate.

**Revendications**

1. Oscillateur stabilisé en température, comprenant un circuit oscillant (1, C, $R_{CU}$), lequel comporte une bobine qui présente une résistance dans le cuivre ($R_{CU}$) et un montage amplificateur (V, $R_1$, $R_2$, $R_3$) connecté en tant que résistance virtuelle négative ($R_n$),

dans lequel l'oscillateur est agencé de manière qu'entre les deux extrémités de la bobine (L) du circuit oscillant, il se développe une tension ($U_{CU}$) qui possède une composante située en dehors de la fréquence de résonance,

lequel oscillateur est **caractérisé en ce qu'**il comprend des moyens avec lesquels on peut tirer, de la tension ($U_{CU}$) qui apparaît entre les deux extrémités de la bobine (L) du circuit oscillant, une première tension ($U_{V1}$) qui est essentiellement proportionnelle à la résistance dans le cuivre ($R_{CU}$) de la bobine (L) du circuit oscillant et qui ne contient aucune composante ayant une fréquence égale à la fréquence de résonance du circuit oscillant, et

**en ce qu'**il comprend un montage de commande ($V_1$, M; $V_2$, $V_3$, M) qui, au moyen de la première tension ($U_{V1}$), rend la résistance virtuelle négative ($R_n$) à peu près inversement proportionnelle à la résistance dans le cuivre ($R_{CU}$) de la bobine (L) du circuit oscillant.

2.  Oscillateur selon la revendication 1, **caractérisé en ce que** le montage de commande ($V_1$, M; $V_2$, $V_3$, M) établit une tension de sortie ($U_{e1}$) du montage amplificateur (V, $R_1$, $R_2$, $R_3$) sur la base d'une deuxième tension ($U_{e2}$) qui est une fonction linéaire de la première tension précitée ($U_{CU}$).

3.  Oscillateur selon la revendication 1, **caractérisé en ce que** la source de courant ($I_1$) est une source de courant continu, une source de courant continu pulsé, ou une source de courant alternatif à basse fréquence.

4.  Oscillateur selon l'une des revendications 1 à 3, **caractérisé en ce que** le montage de commande ($V_1$, M; $V_2$, $V_3$, M) multiplie la tension de sortie ($U_{e1}$) du montage amplificateur (V, $R_1$, $R_2$, $R_3$) par une tension qui est une fonction linéaire du signal ($U_{CU}$).

5.  Oscillateur selon une des revendications 1 à 4, **caractérisé en ce que** le circuit oscillant (L, C, $R_{CU}$) est connecté à l'entrée non inverseuse d'un amplificateur (V) et une première résistance ($R_1$) est connectée à l'entrée inverseuse de l'amplificateur (V), une deuxième résistance ($R_2$) est connectée entre l'entrée inverseuse de l'amplificateur (V) et la sortie de celui-ci, une troisième résistance ($R_3$) est connectée entre l'entrée non inverseuse de l'amplificateur (V) et le montage de commande ($V_1$, M; $V_2$, $V_3$, M), et la sortie de cet amplificateur (V) est connectée au montage de commande ($V_1$, M; $V_2$, $V_3$, M).

6.  Oscillateur selon la revendication 5, **caractérisé en ce que** l'entrée non inverseuse de l'amplificateur (V) est connectée à travers un autre amplificateur ($V_1$; $V_2$, $V_3$) à une entrée d'un multiplicateur (M) dont l'autre entrée est connectée à la sortie de l'amplificateur (V) et dont la sortie est de nouveau connectée à l'entrée non inverseuse de l'amplificateur (V) à travers la troisième résistance ($R_3$).

7.  Oscillateur selon la revendication 6, **caractérisé en ce qu'**un filtre passe-bas ($R_4$, $C_1$) est connecté entre l'une des entrées de l'amplificateur (V) et l'entrée de l'autre amplificateur (1; $V_2$, $V_3$).

8.  Oscillateur selon l'une des revendications 6 ou 7, **caractérisé en ce qu'**une source de tension ($U_0$) est connectée entre la sortie de l'autre amplificateur ($V_1$; $V_2$) et l'entrée du multiplicateur (M) pour ajouter une tension.

9.  Oscillateur selon la revendication 8, **caractérisé en ce que** la source de tension ($U_0$) ajoute à la tension de sortie ($U_{V1}$) de l'autre amplificateur ($V_1$; $V_2$, $V_3$) une tension constante valant k*$U_0$, où k = $R_1$/($R_1$+$R_2$) et la tension $U_0$ est la tension de référence du multiplicateur (M).

10. Oscillateur selon l'une des revendications 8 ou 9, **caractérisé en ce que** la source de courant ($I_1$) est dérivée de la source de tension ($U_0$) ou inversement.

11. Oscillateur selon l'une des revendications 6 à 10, **caractérisé en ce que** l'autre amplificateur est réalisé sous la forme d'un amplificateur de tension continue non inverseur ($V_1$).

12. Oscillateur selon l'une des revendications 6 à 10, **caractérisé en ce que** l'autre amplificateur est réalisé sous la forme d'un amplificateur hacheur ($V_1$).

13. Oscillateur selon l'une des revendications 6 à 10, **caractérisé en ce que** l'autre amplificateur est constitué par un amplificateur de tension alternative non inverseur ($V_2$), cependant qu'un générateur d'horloge (TG), un interrupteur ($S_1$) destiné à synchroniser la source de courant ($I_1$) ainsi qu'un montage d'échantillonnage et de maintien ($S_2$, $C_2$, $V_3$) sont prévus pour reconstituer la composante de tension continue du signal amplifié par l'amplificateur de tension alternative ($V_2$).

14. Utilisation d'un oscillateur selon l'une des revendications 1 à 13 dans un détecteur de proximité.

15. Utilisation d'un oscillateur selon l'une des revendications 1 à 13 dans un détecteur de proximité qui présente un montage d'analyse destiné à fixer le point d'apparition et de disparition de l'oscillation produite par l'oscillateur par suite de l'approche d'une plaque de mesure normalisée.

Fig. 1a

Fig. 1b

Fig. 2

Fig. 3

Fig. 4

EP 0 813 306 B1

11